(19) **Europäisches Patentamt**

**European Patent Office**

**Office européen des brevets**

(11) **EP 1 667 330 A1**

(12) **EUROPEAN PATENT APPLICATION**
published in accordance with Art. 158(3) EPC

(43) Date of publication:
**07.06.2006 Bulletin 2006/23**

(51) Int Cl.:
***H04B 1/04*** (1968.09)   ***H03F 3/24*** (1968.09)

(21) Application number: **04747232.9**

(22) Date of filing: **02.07.2004**

(86) International application number:
**PCT/JP2004/009764**

(87) International publication number:
**WO 2005/015757 (17.02.2005 Gazette 2005/07)**

(84) Designated Contracting States:
**DE FR GB**

(30) Priority: **08.08.2003 JP 2003289893**

(71) Applicant: **MATSUSHITA ELECTRIC INDUSTRIAL CO., LTD.**
**Kadoma-shi, Osaka 571-8501 (JP)**

(72) Inventors:
• **ARAYASHIKI, Mamoru**
**Yokohama-shi, Kanagawa 234-0054 (JP)**

• **HARA, Yoshihiro**
**Hirakata-shi, Osaka 573-1104 (JP)**
• **UDAGAWA, Masaharu**
**Tokyo 155-0033 (JP)**

(74) Representative: **Grünecker, Kinkeldey,**
**Stockmair & Schwanhäusser**
**Anwaltssozietät**
**Maximilianstrasse 58**
**80538 München (DE)**

(54) **TRANSMISSION DEVICE, TRANSMISSION POWER CONTROL METHOD, AND RADIO COMMUNICATION DEVICE**

(57)    The object of the present invention is to provide a transmitting apparatus and a transmitting power control method that can provide excellent power efficiency and a wide control range of transmitting output power, and a radio communication apparatus employing the transmitting apparatus.

At the time of high output power, a high- frequency power amplifier (5) is operated as a nonlinear amplifier, whereby power efficiency when a transmitting signal is power- amplified can be enhanced. Further, at the time of low output power, the high- frequency power amplifier (5) is operated as a linear amplifier, whereby the control range of the transmitting output power can be extended. Still further, when the high- frequency power amplifier (5) is operated as a nonlinear amplifier, by varying the input level of the high- frequency power amplifier (5) according to the average output power of the transmitting signal by the variable gain amplifier (7), it is possible to reduce leak power and to extend the control range of the transmitting output power.

FIG. 1

**Description**

<Technical Field>

The present invention relates to a transmitting apparatus that power- amplifies a transmitting signal and a transmitting power controlling method, and a radio communication apparatus using this transmitting apparatus.

<Background Art>

In a conventional high- frequency power amplifier for amplifying a modulated signal including an envelope variation component, an A-class or AB-class linear amplifier has been used to amplify the envelope variation component linearly. Such a linear amplifier is excellent in linearity but is inferior in power efficiency to a C-class or E-class non-linear amplifier because the linear amplifier always consumes power incident to a direct current bias component. For this reason, when such a high- frequency power amplifier is applied to a portable radio powered by a battery, there are brought about circumstances that the hours of use are shortened because the high- frequency power amplifier consumes large power. Moreover, when such high- frequency power amplifiers are applied to the base station equipment of a radio system having a plurality of high- power transmitting apparatuses, there are brought about circumstances that the base station equipment result in increasing in size and in the amount of heat.

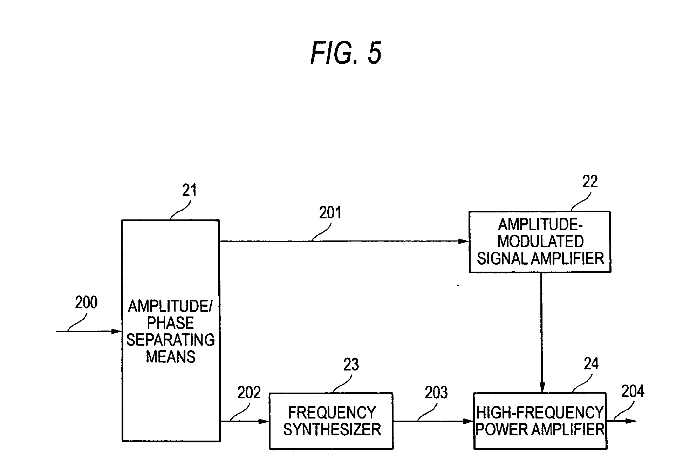

Hence, a transmitting apparatus using polar modulation, which is proposed as a transmitting apparatus of high-efficiency, is shown in FIG. 5. As shown in FIG. 5, this transmitting apparatus has an amplitude/phase separating means 21, an amplitude- modulated signal amplifier 22, a frequency synthesizer 23, and a high- frequency power amplifier 24 of a nonlinear amplifier.

A base-band modulated signal 200 is inputted to the amplitude/phase separating means 21, a base- band amplitude- modulated signal 201 is inputted to the amplitude- modulated signal amplifier 22 from the amplitude/ phase separating means 21, a base- band phase- modulated signal 202 is inputted to the frequency synthesizer 23 from the amplitude/ phase separating means 21, a high- frequency phase-modulated signal 203 is inputted to the high- frequency power amplifier 24 from the frequency synthesizer 23, and a transmitting output signal 204 is outputted from the high-frequency power amplifier 24.

Next, the operation of this transmitting apparatus will be described. First, assuming that the base- band modulated signal 200 is Si(t), it is expressed by an equation (1).

$$Si(t) = a(t) \times exp[j\varphi(t)] \qquad (1)$$

where a(t) is amplitude data and exp[j$\varphi$(t)] is phase data, respectively. The amplitude data a(t) and the phase data exp [j$\varphi$(t)] are extracted by the amplitude/ phase separating means 21. Here, the amplitude data a(t) corresponds to the base- band amplitude- modulated signal 201 and the phase data exp[j$\varphi$(t)] corresponds to the base- band phase-modulated signal 202, respectively. The amplitude data a(t) is amplified by the amplitude- modulated signal amplifier 22 and is applied to the high- frequency power amplifier 24. With this, the power supply voltage of the high- frequency power amplifier 24 is set on the basis of the amplitude data a(t).

The frequency synthesizer 23 produces a high- frequency phase-modulated signal 203 obtained by modulating a carrier wave angular frequency $\omega c$ by the phase data exp[j$\varphi$(t)] and this high- frequency phase- modulated signal 203 is inputted to the high- frequency power amplifier 24. Here, assuming that the high- frequency phase-modulated signal 203 is a signal Sc, it is expressed by an equation (2).

$$Sc = expj[\omega c \times t + \varphi(t)] \qquad (2)$$

By applying a nonlinear amplifier to the high- frequency power amplifier 24, the transmitting output signal 204, which is produced by amplifying a signal, which is obtained by multiplying the power supply voltage a(t) of this high-frequency power amplifier 24 by the output signal of the frequency synthesizer 23, by a gain G of the high-frequency power amplifier 24, is outputted from the high- frequency power amplifier 24. Here, assuming that the transmitting output signal 204 is an RF signal Srf, it is expressed by an equation (3).

$$Srf = Ga \times (t)Sc = Ga(t) \times expj[\omega c \times t + \varphi(t)] \qquad (3)$$

Because the signal inputted to the high- frequency power amplifier 24 is a phase- modulated signal not having a variation component in the direction of amplitude, it becomes a constant envelope signal. Hence, a nonlinear amplifier of high efficiency can be used as the high-frequency power amplifier 24, so that it is possible to provide a transmitting apparatus of high efficiency. A technology of using this kind of polar modulation is described in, for example, patent document 1 or patent document 2.

[Patent document 1] Specification of Japanese Patent No. 3207153

[Patent document 1] Japanese Unexamined Patent Publication No. 2001-156554

However, in the conventional transmitting apparatus described above, in the case of controlling the output power of the high- frequency power amplifier 24, an output signal does not change linearly with respect to an input signal because the high- frequency power amplifier 24 is a nonlinear amplifier. Hence, an output power control also needs to be performed by changing power supply voltage in the same way as amplitude modulation. In this case, there are brought about circumstances that the control range of output power is limited by the operation limits of a transistor to the leak power or the power supply voltage.

The invention has been made in view of the conventional circumstances described above. The object of the invention is to provide a transmitting apparatus and a transmitting power controlling method that can provide excellent power efficiency and a wide control range of transmitting output power, and a radio communication apparatus using this transmitting apparatus.

<Disclosure of the Invention>

A transmitting apparatus of the present invention is a transmitting apparatus that power- amplifies and outputs a transmitting signal, and includes transmitting power amplifying means having a high- frequency power amplifier, wherein the transmitting power amplifying means has a first mode of operating the high- frequency power amplifier as a nonlinear amplifier and a second mode of operating the high- frequency power amplifier as a linear amplifier, and, in the first mode, amplitude modulates the transmitting signal and controls the average output power level of the transmitting signal by a power supply voltage of the high-frequency power amplifier and, in the second mode, controls the average output power level of the transmitting signal before the high-frequency power amplifier and amplitude modulates the transmitting signal having the average output level controlled.

With this construction, in the first mode, for example, at the time of outputting high power, by operating the high- frequency power amplifier as a nonlinear amplifier, it is possible to increases power efficiency remarkably, and in the second mode, for example, at the time of outputting low power, by operating the high- frequency power amplifier as a linear amplifier, it is possible to control transmitting output power over a wide range and to use one amplifier extremely efficiently and to increase power efficiency remarkably.

Further, in the transmitting apparatus of the invention, the transmitting power amplifying means has a multiplier disposed before the high- frequency power amplifier and a variable gain amplifier disposed before the multiplier, and, in the second mode, amplitude modulates the transmitting signal by the multiplier and controls the average output power level of the transmitting signal by the variable gain amplifier.

With this construction, in the second mode, the high- frequency power amplifier operates as a linear amplifier and hence its power supply voltage is constant and the high- frequency power amplifier can not amplitude modulate the transmitting signal and can not control the average output level of the transmitting signal. Hence, the multiplier disposed before the high- frequency power amplifier amplitude modulates the transmitting signal and the variable gain amplifier disposed before the multiplier controls the average output level of the transmitting signal to make the high- frequency power amplifier operate as a linear amplifier. With this, it is possible to control the transmitting output power over a wide range.

Further, the transmitting apparatus of the invention changes the input level of the high- frequency power amplifier according to the average output power of the transmitting signal in the first mode.

With this construction, the input level of the high- frequency power amplifier is changed according to the average output power of the transmitting signal, so that it is possible to reduce leak power and to extend the control range of transmitting power by the power supply voltage when the high- frequency power amplifier operates as a nonlinear amplifier.

Still further, the transmitting apparatus of the invention changes the input level of the high- frequency power amplifier according to the instantaneous output power of the transmitting signal in the first mode.

With this construction, the input level of the high- frequency power amplifier is changed according to the instantaneous output power of the transmitting signal, so that it is possible to follow an instantaneous change in the level and to reduce leak power and hence to improve the recurrence of an instantaneous change in the level.

Still further, a method of controlling a transmitting power according to the invention is a method of controlling a transmitting power when a transmitting signal is power- amplified and outputted by a high-frequency power amplifier, and includes the steps of: operating the high-frequency power amplifier as a nonlinear amplifier in a first mode to amplitude modulate the transmitting signal and to control the average output level of the transmitting signal by the power supply voltage of the high- frequency power amplifier; and operating the high- frequency power amplifier as a linear amplifier in the second mode to control the average output level of the transmitting signal before the high-frequency power amplifier and to amplitude modulate the transmitting signal having the average output level controlled.

With this construction, it is possible to enhance power efficiency remarkably in the first mode of operating the high- frequency power amplifier as a nonlinear amplifier and to control the transmitting output power over a wide range in the first mode and in second mode of operating the high- frequency power amplifier as a linear amplifier.

Still further, a radio communication apparatus of the invention is a radio communication apparatus for transmitting a transmitting signal from an antenna by radio and has a construction in which the transmitting signal is power-amplified by the transmitting apparatus and is outputted to the antenna.

With this construction, the power efficiency of the transmitting apparatus in the first mode is high and hence the period of use of a battery power supply mounted in the apparatus can be elongated and the high- frequency power amplifier of the transmitting apparatus can be reduced in size, so that it is possible to make a more reduction in the size of the radio communication apparatus.

According to the transmitting apparatus, the method of controlling transmitting power, and the radio communication apparatus in accordance with the invention, it is possible to make power efficiency excellent and to extend the control range of transmitting output power.

<Brief Description of the Drawings>

Fig. 1 is a block diagram showing the general construction of a transmitting apparatus in the first embodiment of the invention.

Fig. 2 is a block diagram showing a circuit construction when the high- frequency power amplifier shown in FIG. 1 is used as a nonlinear amplifier.

Fig. 3 is a graph useful in explaining an operation when the high-frequency power amplifier shown in FIG. 1 is used as a nonlinear amplifier.

Fig. 4 is a block diagram showing the general construction of a transmitting system of a radio communication apparatus in the second embodiment of the invention.

Fig. 5 is a block diagram showing the construction example of a conventional transmitting apparatus.

Here, a reference numeral 1 in the drawings denotes amplitude/phase separating means, 2 and 8 denote multipliers, 3 and 10 denote switches, 4 denotes an amplitude- modulated signal amplifier 22, 5 denotes a high- frequency power amplifier, 6 denotes a frequency synthesizer 23, 7 denotes a variable gain amplifier, 9 denotes a low-limit limiting circuit, 11 denotes an adder, 12 denotes a transmission/reception selector switch, and 13 denotes an antenna.

<Best Mode for Carrying Out the Invention>

(First Embodiment)

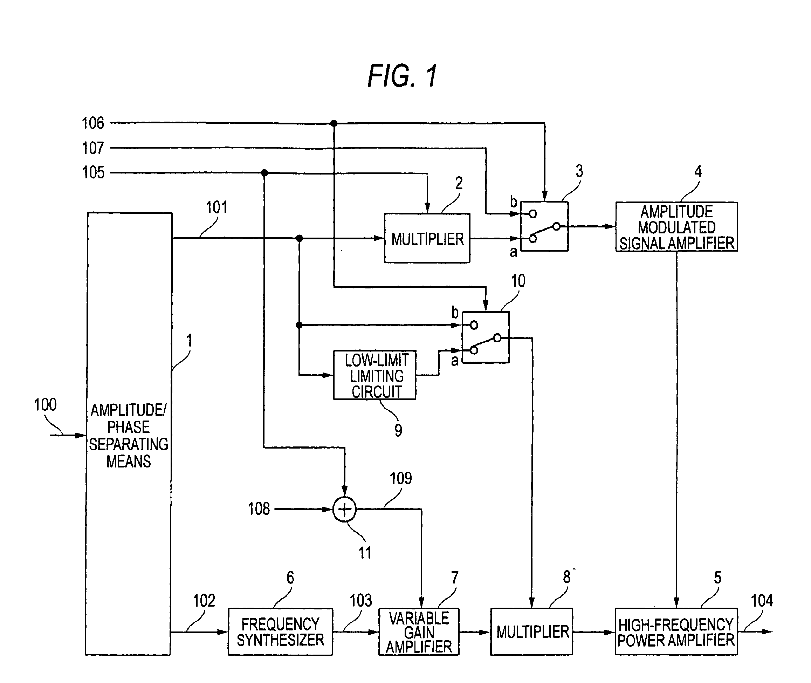

FIG. 1 is a block diagram showing the general construction of a transmitting apparatus so as to describe an embodiment of the invention. As shown in FIG. 1, the transmitting apparatus of this embodiment includes amplitude/phase separating means 1 that separates a base-band modulated signal 100 into a base band amplitude- modulated signal 101 and a base- band phase- modulated signal 102, a multiplier 2 that multiplies the base band amplitude- modulated signal 101 by a gain control signal 105, a switch 3 that is switched on the basis of a mode switching signal 106, an amplitude- modulated signal amplifier 4 that supplies a high- frequency power amplifier 5 with a power supply voltage, the high- frequency power amplifier 5 that amplifies the power of an input signal from a multiplier 8 and outputs a transmitting output signal 104, a frequency synthesizer 6 that phase modulates a carrier wave signal by the base-band phase- modulated signal 102 to produce a high- frequency phase- modulated signal 103, a variable gain amplifier 7 that adjusts the signal level of the high- frequency phase- modulated signal 103, the multiplier 8 that multiplies the output of the variable gain amplifier 7 by the base- band amplitude- modulated signal 101, a low-limit limiting circuit 9 that limits the low limit of amplitude variation of the base- band amplitude- modulated signal 101, a switch 10 that is switched by the mode switching signal 106, and an adder 11 that adds a gain offset signal 108 and the base- band amplitude- modulated signal 101.

The operation of the transmitting apparatus constructed in the manner described above will be described. In FIG. 1, the operating mode of the high- frequency power amplifier 5 is determined, for example, according to the level of a transmitting power specified to a transmitting apparatus from a radio base station or a transmitting power level based on the state of a receiving signal of the transmitting apparatus. When the level of the transmitting output signal 104 is high, an operating mode in which the high- frequency power amplifier 5 becomes a nonlinear amplifier is desirable from the viewpoint of power efficiency. On the other hand, when the level of the transmitting output signal 104 is low and hence the operating mode is out of a range in which the high- frequency power amplifier 5 can operate as a nonlinear amplifier, it is necessary to make the high- frequency power amplifier 5 operate as a linear amplifier. The mode switching signal 106 is set on the basis of a desired level of transmitting power and the characteristics of the high- frequency power amplifier 5. Here, the gain control signal 105, the mode switching signal 106, a DC voltage 107, and a gain offset signal 108, which are inputted to the transmitting apparatus, are set by a control section (not shown). This control section may be provided in the transmitting apparatus itself. Further, when the transmitting apparatus is mounted in a radio communication apparatus or the like, it may be shared for use with a control section for controlling the operation of the radio communication apparatus.

First, a case will be described in which the level of the transmitting output signal 104 of the high- frequency power amplifier 5 shown in FIG. 1 is comparatively high. In this case, the high- frequency power amplifier 5 operates as a nonlinear amplifier in a saturated operation region of a switching operation region. The base- band modulated signal 100 is separated by the amplitude/phase separating means 1 into the base- band amplitude- modulated signal 101 and the base- band phase- modulated signal 102.

The base- band amplitude- modulated signal 101 is multiplied by the gain controlling signal 105 by the multiplier 2 and is inputted to the terminal a of the switch 3. When the transmitting output signal is amplitude modulated by the high- frequency power amplifier 5 (the level of the transmitting output signal is comparatively high), the terminals a and c of the switch 3 are connected to each other by the mode switching signal 106. The product of the base- band amplitude- modulated signal 101 and the gain controlling signal 105, which is outputted from the terminal c of the switch 3, is amplified by the amplitude- modulated signal amplifier 4 and is applied as the power supply voltage of the high-frequency power amplifier 5 to the high- frequency power amplifier 5 and is amplitude modulated by the high- frequency power amplifier 5.

Here, to change a power supply voltage at high efficiency according to the level of the base- band amplitude- modulated signal 101, it is preferable to use a D-class amplifier showing amplitude information by a band width for the amplitude- modulated signal amplifier 4.

On the other hand, the base- band phase- modulated signal 102 is inputted to the frequency synthesizer 6. The frequency synthesizer 6 phase modulates the carrier wave signal by the base- band phase-modulated signal 102 to produce and output the high- frequency phase-modulated signal 103. This high- frequency phase- modulated signal 103 is amplified (or attenuated) by the variable gain amplifier 7 on the basis of the gain controlling signal 109 and then is outputted to the multiplier 8.

Here, the gain controlling signal 109 inputted to the variable gain amplifier 7 is obtained by adding the gain offset signal 108 to the rain controlling signal 105 by the adder 11. The gain offset signal 108 is set such that the variable gain amplifier 7 adjusts the high- frequency phase- modulated signal 103 to a level suitable for operating the high-frequency power amplifier 5 as a nonlinear amplifier in the saturated operation region or in the switching operation region.

When the level of the transmitting output signal is comparatively high, the terminals a and c of the switch 10 are connected to each other by the mode switching signal 106. For this reason, a signal of limiting the low limit of amplitude variation of the base- band amplitude-modulated signal 101 by the low- limit limiting circuit 9 is outputted to the multiplier 8 through this switch 10.

With this, a signal obtained by multiplying the output of the variable gain amplifier 7 by the signal of limiting the low limit of amplitude variation of the base- band amplitude- modulated signal 101 by the multiplier 8 becomes a phase-modulated signal. The phase-modulated signal outputted from the multiplier 8 is inputted to the high-frequency power amplifier 5 and is multiplied by the amplitude-modulated signal and then is outputted as the transmitting output signal 104.

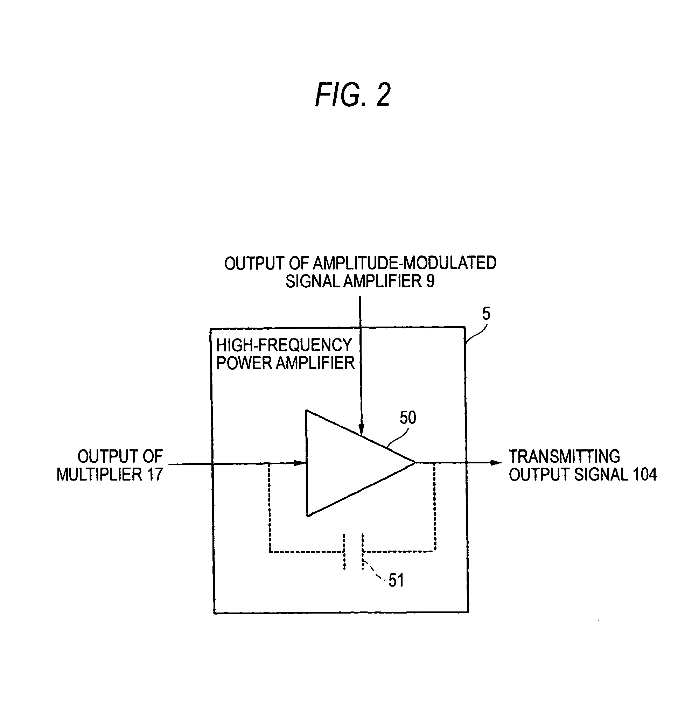

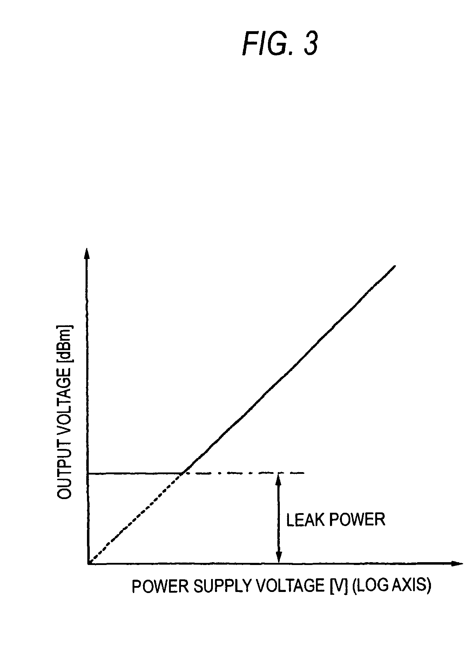

FIG. 2 shows the circuit construction of the high- frequency power amplifier 5 when it is used as a nonlinear amplifier, and FIG. 3 is a graph to explain the operation of the high- frequency power amplifier 5 when it is used as a nonlinear amplifier. As shown in FIG. 2, the high-frequency power amplifier 5 has a construction including a nonlinear amplifier 50 and having a parasitic capacitance 51 connected between its input side and output side. FIG. 3 shows the relationship between the power supply voltage and the output power of the nonlinear amplifier 50. As shown in FIG. 3, in the nonlinear amplifier 50, the output power is proportional to the square of the power supply voltage. Here, the magnitude of leak power is determined by the parasitic capacitance 51 and the level of input signal of the nonlinear amplifier 50 (level of output signal of the multiplier 8).

Here, considering a case where the variable gain amplifier 7 and the multiplier 8 are not provided, the output of the frequency synthesizer 6 is nearly constant and hence the leak power also becomes constant. In this case, to decrease the level of transmitting output signal 104, it is recommendable to decrease the power supply voltage of the nonlinear amplifier 50, but the power supply voltage of the nonlinear amplifier 50 is limited by the leak power and hence can not be decreased to a level lower than a predetermined value.

On the other hand, in this embodiment, the gain of the variable gain amplifier 7 is controlled by the gain controlling signal 109 to control the level of the phase- modulated signal inputted to the high- frequency power amplifier 5, whereby the leak power can be decreased. Hence, in the high- frequency power amplifier 5, the control range of output power by the power supply voltage can be extended. In this manner, by amplifying the base- band phase- modulated signal on the basis of the gain controlling signal 105 for setting the average output of the amplitude- modulated signal, it is possible to make the level of the phase- modulated signal by the variable gain amplifier 7 follow the average power of the amplitude- modulated signal, that is, to control the input of the high- frequency power amplifier 5 according to the average output power.

Further, by multiplying the output signal of the variable gain amplifier 7 by the base- band amplitude- modulated signal 101 by the multiplier 8, the input level of the high- frequency power amplifier 5 follows an instantaneous variation in the level of the amplitude variation signal and the leak power also decreases, so that it is possible to improve the recurrence of instantaneous variation in the level. That is, it is possible to control the input of the high- frequency power amplifier 5 according to an instantaneous output power.

Here, when the input level of the high- frequency power amplifier 5 is decreased too much, the high- frequency power amplifier 5 is out of the saturated operation region or the switching operation region and hence linearity to a change in power supply voltage deteriorates. Hence, the input level of the high- frequency power amplifier 5 is kept higher than a predetermined level by the low- limit limiting circuit 9. In this regard, because it is essential only that the multiplier 8 decreases the leak power in accordance with amplitude variation without multiplying the transmitting output signal 104 by the amplitude-modulated signal, there is no problem even if the low level side of the instantaneous variation in the level is limited in the multiplier 8.

Next, a case where the level of the transmitting output signal 104 is comparatively low will be described. In this case, the high- frequency power amplifier 5 operates as a linear amplifier in which output is linear to input. First, the terminals b and c of the switch 3 are connected to each other by the mode switching signal 106. With this, the DC voltage 107 is inputted from the amplitude- modulated signal amplifier 4 through the switch 3 and the amplitude- modulated signal amplifier 4 applies a constant power supply voltage to the high- frequency power amplifier 5.

On the other hand, the base- band phase- modulated signal 102 is inputted to the frequency synthesizer 6, and the frequency synthesizer 6 outputs the high- frequency phase- modulated signal 103, obtained by modulating a carrier wave signal by the base- band phase- modulated signal 102, to the variable gain amplifier 7. The high- frequency phase-modulated signal 103 is amplified (or attenuated) by the variable gain amplifier 7 on the basis of the gain controlling signal 109 and is inputted to the multiplier 8. At this time, the gain offset signal 108 is set at zero. Therefore, the gain controlling signal 105 (= gain controlling signal 109) is inputted to the variable gain amplifier 7 through the adder 11.

Further, in this case, the terminals b and c of the switch 10 are connected to each other by the mode switching signal 106. Hence, the base- band amplitude- modulated signal 101 is inputted through the switch 10 to the multiplier 8. The multiplier 8 multiplies the high-frequency phase- modulated signal 103, amplified by the variable gain multiplier 7, by the base- band amplitude- modulated signal 101. The high- frequency power amplifier 5 amplifies the output of the multiplier 8 linearly and outputs the transmitting output signal 104.

In this manner, even when the level of the transmitting output signal is low and the high- frequency power amplifier 5 may be out of the saturated operation region or the switching operation region, that is, even when there is a possibility that the high- frequency power amplifier 5 deteriorates in the linearity of the output power to a change in the power supply voltage, by operating the high- frequency power amplifier 5 as a linear amplifier, it is possible for the high-frequency power amplifier 5 to keep the linearity of the output signal to the input signal and to extend the output power control range.

According to the embodiment of this invention, when the level of the transmitting output signal is comparatively high, the high- frequency power amplifier 5 is used as a nonlinear amplifier to modulate the amplitude of the transmitting signal and to control the average output level thereof by the power supply voltage applied to the high- frequency power amplifier 5, and when the level of the transmitting output signal is comparatively low, the high- frequency power amplifier 5 is used as a linear amplifier and the multiplier 8 provided before the high- frequency power amplifier 5 modulates the amplitude of the transmitting signal and the variable gain amplifier 7 provided before the multiplier 8 controls the average output level thereof. With this, it is possible to control the level of the transmitting output signal over a wide range.

Further, when the transmitting power is large, the high- frequency power amplifier 5 is operated as a nonlinear amplifier and hence power efficiency can be enhanced.

Still further, when the high- frequency power amplifier 5 is operated as a nonlinear amplifier, if the gain of the variable gain amplifier 7 is controlled by the gain controlling signal 109 to vary the level of the high-frequency phase-modulated signal 103, leak power is decreased, so that it is possible to extend the control range of output power by the power supply voltage.

Still further, when the multiplier 8 multiplies the high- frequency phase- modulated signal 103 by the base band amplitude- modulated signal 101, the input level of the high-frequency power amplifier 5 follows an instantaneous variation in the level of the base- band amplitude- modulated signal 101 and leak power also decreases, so that it is possible to improve the recurrence of the instantaneous variation in the level.

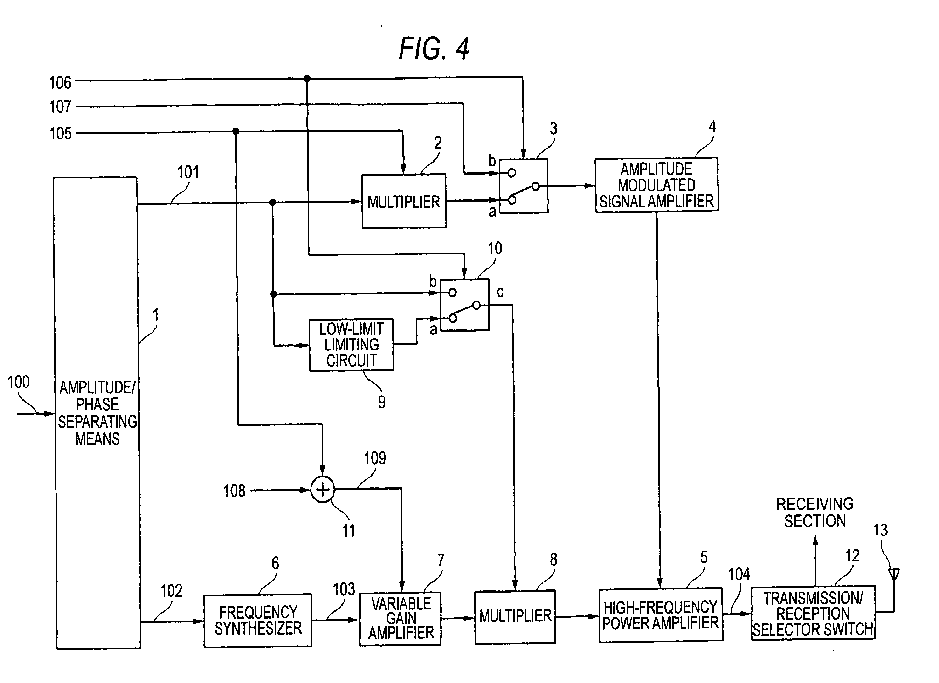

FIG. 4 is a block diagram showing the general construction of a transmitting system of a radio communication apparatus having the transmitting apparatus of the embodiment described in FIG. 1. Here, the radio communication apparatus includes, for example, a portable radio terminal apparatus such as a mobile phone or a personal digital assistant having a communication function, a radio base station, and the like. Here, in the example shown in FIG. 4 is shown a case where the transmitting apparatus of this embodiment is applied to a portable radio terminal apparatus. The portable radio terminal apparatus has a transmission/reception selector switch 12 and an antenna 13 on the output side of the high- frequency power amplifier 5 shown in the first embodiment.

Next, the operation of the portable radio terminal apparatus shown in FIG. 4 will be described. At the time of transmission, the high-frequency power amplifier 5 radiates the power- amplified transmitting power signal 104 from the antenna 13 via the transmission/ reception selector switch 12. On the other hand, at the time of reception, a receiving signal is inputted to a receiving section (not shown) from the antenna 13 via the transmission/ reception selector switch 12.

According to the portable radio terminal apparatus of this embodiment, the high- frequency power amplifier 5 operates as a nonlinear amplifier at the time of outputting high power to enhance power efficiency to prevent the consumption of a battery, whereby the hours of use can be elongated. Further, the high- frequency power amplifier 5 is enhanced in power efficiency and hence can be reduced in size and in the quantity of heat. Hence, a radio communication apparatus mounted with the high- frequency power amplifier 5 can be reduced in size.

Further, if the invention is applied to the base station equipment of a radio system mounted with a plurality of high- power transmitting apparatuses, the power efficiency when the high- frequency power amplifier outputs high output power is enhanced and hence the high-frequency power amplifier can be reduced in size and in the quantity of heat, so that it is possible to prevent the equipment from being increased in size and hence to reduce installation space.

In this regard, the invention is not limited to the above embodiment, but other various embodiments can be also put into practice in the specific construction, function, operation, and effect without departing from the gist of the invention.

While the invention has been described with reference to the specific embodiments, it is apparent to those skilled in the art that various alternatives and modifications can be made without departing from the spirit and scope of the invention as claimed in the appended claims.

The present application is based on Japanese Patent Application No. 2003-289893 filed on August 8, 2003, the content of which will be hereby incorporated by reference into this application.

<Industrial Applicability>

The present invention produces effects of producing excellent power efficiency and controlling transmitting output power over a wide range and hence can be usefully applied to a portable terminal apparatus such as mobile telephone or personal digital assistant, and a radio communication apparatus of the like of a radio base station or the like.

**Claims**

1. A transmitting apparatus that power- amplifies a transmitting signal, the apparatus comprising transmitting power amplifying means having a high- frequency power amplifier, wherein the transmitting power amplifying means has a first mode of operating the high- frequency power amplifier as a nonlinear amplifier and a second mode of operating the high- frequency power amplifier as a linear amplifier, and in the first mode, amplitude modulates the transmitting signal and controls an average output level of the transmitting signal by a power supply voltage of the high- frequency power amplifier and, in the second mode, controls an average output level of the transmitting signal before the high-frequency power amplifier and amplitude modulates the transmitting signal having the average output level controlled.

2. The transmitting apparatus as claimed in claim 1, wherein the transmitting power amplifying means has a multiplier disposed before the high- frequency power amplifier and a variable gain amplifier disposed before the multiplier, and, in the second mode, amplitude modulates the transmitting signal by the multiplier and controls the average output level of the transmitting signal by the variable gain amplifier.

3. The transmitting apparatus as claimed in claim 1 or claim 2, wherein an input level of the high- frequency power amplifier is changed according to an average output power of the transmitting signal in the first mode.

4. The transmitting apparatus as claimed in any one of claims 1 to 3, wherein an input level of the high- frequency power amplifier is changed according to an instantaneous output power of the transmitting signal in the first mode.

5. A method of controlling a transmitting power when a transmitting signal is power amplified and outputted by a high- frequency power amplifier, the method comprising the steps of:

operating the high- frequency power amplifier as a nonlinear amplifier in a first mode to amplitude modulate the transmitting signal and to control an average output level of the transmitting signal by a power supply voltage of the high- frequency power amplifier; and operating the high- frequency power amplifier as a linear amplifier in a second mode, before the high- frequency power amplifier, to control an average output level of the transmitting signal and further to amplitude modulate the transmitting signal having the average output level controlled.

6. A radio communication apparatus for transmitting a transmitting signal from an antenna by radio, wherein the transmitting signal is power amplified by the transmitting apparatus as claimed in any one of claims 1 to 4 and is outputted to the antenna.


**Amended claims under Art. 19.1 PCT**

1. A transmitting apparatus that power- amplifies a transmitting signal, the apparatus comprising transmitting power amplifying means having a high- frequency power amplifier, wherein the transmitting power amplifying means has a first mode of operating the high- frequency power amplifier as a nonlinear amplifier and a second mode of operating the high- frequency power amplifier as a linear amplifier, and in the first mode, amplitude modulates the transmitting signal and controls an average output level of the transmitting signal by a power supply voltage of the high- frequency power amplifier and, in the second mode, controls an average output level of the transmitting signal before the high- frequency power amplifier and amplitude modulates the transmitting signal having the average output level controlled.

2. The transmitting apparatus as claimed in claim 1, wherein the transmitting power amplifying means has a multiplier disposed before the high- frequency power amplifier and a variable gain amplifier disposed before the multiplier, and, in the second mode, amplitude modulates the transmitting signal by the multiplier and controls the average output level of the transmitting signal by the variable gain amplifier.

3. The transmitting apparatus as claimed in claim 1, wherein an input level of the high- frequency power amplifier is changed according to an average output power of the transmitting signal in the first mode.

4. The transmitting apparatus as claimed in claim 1, wherein an input level of the high- frequency power amplifier is changed according to an instantaneous output power of the transmitting signal in the first mode.

5. A method of controlling a transmitting power when a transmitting signal is power amplified and outputted by a high- frequency power amplifier, the method comprising the steps of:

operating the high- frequency power amplifier as a nonlinear amplifier in a first mode to amplitude modulate the transmitting signal and to control an average output level of the transmitting signal by a power supply voltage of the high- frequency power amplifier; and operating the high- frequency power amplifier as a linear amplifier in a second mode, before the high- frequency power amplifier, to control an average output level of the transmitting signal and further to amplitude modulate the transmitting signal having the average output level controlled.

6. A radio communication apparatus for transmitting a transmitting signal from an antenna by radio, wherein the transmitting signal is power amplified by the transmitting apparatus as claimed in claim 1 and is outputted to the antenna.

FIG. 1

EP 1 667 330 A1

# FIG. 2

OUTPUT OF AMPLITUDE-MODULATED
SIGNAL AMPLIFIER 9

5

HIGH-FREQUENCY
POWER AMPLIFIER

50

OUTPUT OF
MULTIPLIER 17

TRANSMITTING
OUTPUT SIGNAL 104

51

# FIG. 3

FIG. 4

AMPLITUDE/PHASE SEPARATING MEANS — 1

AMPLITUDE MODULATED SIGNAL AMPLIFIER — 4

MULTIPLIER — 2

LOW-LIMIT LIMITING CIRCUIT — 9

MULTIPLIER — 8

VARIABLE GAIN AMPLIFIER — 7

FREQUENCY SYNTHESIZER — 6

HIGH-FREQUENCY POWER AMPLIFIER — 5

TRANSMISSION/RECEPTION SELECTOR SWITCH — 12

RECEIVING SECTION

3, 10, 11, 13

100, 101, 102, 103, 104, 105, 106, 107, 108, 109

*FIG. 5*

<div align="center">**INTERNATIONAL SEARCH REPORT**</div>

| | International application No. |
|---|---|
| | PCT/JP2004/009764 |

A. CLASSIFICATION OF SUBJECT MATTER
  Int.Cl⁷ H04B1/04, H03F3/24

According to International Patent Classification (IPC) or to both national classification and IPC

B. FIELDS SEARCHED

Minimum documentation searched (classification system followed by classification symbols)
  Int.Cl⁷ H04B1/04, H03F3/24

Documentation searched other than minimum documentation to the extent that such documents are included in the fields searched
  Jitsuyo Shinan Koho        1922-1996   Toroku Jitsuyo Shinan Koho   1994-2004
  Kokai Jitsuyo Shinan Koho   1971-2004   Jitsuyo Shinan Toroku Koho   1996-2004

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| A | JP 2000-286915 A (Toshiba Corp.), 13 October, 2000 (13.10.00), Par. Nos. [0050] to [0067]; Figs. 1, 4 & WO 2000/59172 A1 & EP 1170915 A1 & US 2002/0031191 A1 | 1-6 |
| A | JP 2002-33672 A (Lucent Technologies Inc.), 31 January, 2002 (31.01.02), Par. Nos. [0012] to [0036]; Fig. 2 & EP 1162733 A2 &US 6546233 B1 | 1-6 |
| A | JP 6-45993 A (Kyocera Corp.), 18 February, 1994 (18.02.94), Par. Nos. [0008] to [0013]; Figs. 1, 5, 6 (Family: none) | 1-6 |

| ☒ Further documents are listed in the continuation of Box C. | ☐ See patent family annex. |
|---|---|

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search 05 October, 2004 (05.10.04) | Date of mailing of the international search report 19 October, 2004 (19.10.04) |
|---|---|
| Name and mailing address of the ISA/ Japanese Patent Office | Authorized officer |
| Facsimile No. | Telephone No. |

Form PCT/ISA/210 (second sheet) (January 2004)

**EP 1 667 330 A1**

| INTERNATIONAL SEARCH REPORT | International application No. |
| | PCT/JP2004/009764 |

C (Continuation). DOCUMENTS CONSIDERED TO BE RELEVANT

| Category* | Citation of document, with indication, where appropriate, of the relevant passages | Relevant to claim No. |
|---|---|---|
| A | JP 10-190755 A (Toshiba Corp.), 21 July, 1998 (21.07.98), Par. Nos. [0017] to [0040]; Figs. 1, 6 (Family: none) | 1-6 |

Form PCT/ISA/210 (continuation of second sheet) (January 2004)

15